# EUROPÄISCHE PATENTSCHRIFT

(11) **EP 0 588 893 B1**
(45) Veröffentlichungstag und Bekanntmachung des Hinweises auf die Patenterteilung: **16.08.1995**
(21) Anmeldenummer: 92912363.6
(22) Anmeldetag: 12.06.1992
(51) Int. Cl.: H05K 7/16

(54) **GEHÄUSE FÜR EINSCHÜBE VON ELEKTRONIKBAUGRUPPEN**
HOUSING FOR PLUG-IN PACKAGES OF ELECTRONIC COMPONENTS
BOITIER POUR PLAQUES EMBROCHABLES DE COMPOSANTS ELECTRONIQUES

(30) Priorität: 13.06.1991 AT 1187/91
(43) Veröffentlichungstag der Anmeldung: 30.03.1994
(73) Patentinhaber: ELIN ENERGIEVERSORGUNG GESELLSCHAFT m.b.H., 1141 Wien (AT)
(72) Erfinder: WENDL, Kurt, A-1140 Wien (AT)
(74) Vertreter: Krause, Peter
(86) Internationale Anmeldenummer: AT9200076
(87) Internationale Veröffentlichungsnummer: WO9222998

(56) Entgegenhaltungen:
- EP-A- 0 418 869
- WO-A-88/02593
- DD-A- 230 743
- DE-A- 3 933 319
- GB-A- 2 034 528

## Beschreibung

Die Erfindung betrifft ein Gehäuse für Einschübe von Elektronikbaugruppen, sowie die Anordnung von bauteilbestückten Leiterplatten und anderen Bauteilen in diesem, wobei eine Gehäusewand in den beiden benachbarten Gehäuseseitenwänden mittels an ihr befestigten Zapfen nach unten ausschwenkbar gelagert ist und die Drehachse in einem Abstand parallel zur Grundplatte des Gehäuses liegt.

In der EP-OS 0 418 869 ist ein Unternetzverteilergehäuse dargestellt, bei dem an der Vorderseite eine nach unten schwenkbare Klappe angeordnet ist. Der Fig. in dieser Schrift ist zu entnehmen, daß der Drehpunkt der Klappe oberhalb des Gehäusebodens liegt und in das Innere des Gehäuses versetzt ist. Dies ist hier für einen sinnvollen Schwenkbereich von 90° deshalb notwendig, weil die Klappe beidseitig nach innen gebogen ist und der Drehpunkt auch noch auf einer Fahne des umgebogenen Teiles liegt. Bei senkrechter Position der Klappe ergibt sich daher unter ihr auch ein schmaler Spalt der zur Belüftung des Gehäuses dient. Auf der Rückseite der Klappe sind Sicherungsautomaten, welche von vorne zu betätigen sind, befestigt. Weiters sind auf der Rückseite der Klappe auch Klemmen angeordnet, die nur in waagrechter also geschwenkter Position zugänglich sind. Über die Verbindungen zu den Klemmen und den Sicherungsautomaten wird in dieser Veröffentlichung nichts erwähnt.

Aufgrund der immer weiteren Verbreitung von Mikroprozessoren in der Steuerungs- und Kraftwerkstechnik, in letzterer vor allem im Bereich der Schutztechnik, werden die Abmessungen der dabei benötigten Gehäuse immer kleiner. Die Anzahl der diesem Gehäuse zugeführten Leitungen und Kabel bleibt mindestens gleich, wird jedoch aufgrund geforderter höherer Überwachungsansprüche und Sicherheit immer größer.
Die Leiterplatten, sowie die Anschlüsse für die zugeführten Leitungen und Kabel sollen für Messungen bei der Inbetriebnahme und im Störfall jedoch leicht zugänglich sein. Weiters soll auch eine gewisse Übersichtlichkeit im Gehäuse gewahrt bleiben.

Die Aufgabe der Erfindung besteht nun darin, ein Gehäuse. für Einschübe von Elektronikbaugruppen derart zu adaptieren, und auch die Leiterplatten, sowie die Anschlüsse. der externen Zuleitungen so anzuordnen, daß obige Anforderungen erfüllt werden.

Die Aufgabe wird durch die Erfindung gelöst. Diese ist dadurch gekennzeichnet, daß die Gehäusewand die Rückwand ist und diese von der Drehachse bis zur oberen Deckplatte des Gehäuses reicht, und daß an der Außenseite der Rückwand Bauteile, insbesondere Stromwandler, befestigt sind, deren Sekundäranschlüsse durch die Rückwand ragen, und daß außen an der Rückwand nahe der Drehachse Klemmen, vorzugsweise Schraubklemmen, nebeneinander befestigt sind, an denen einerseits die Primärseiten der Bauteile, insbesondere Stromwandler und andererseits extern zugeführte Leitungen angeschlossen sind, und daß an der Innenseite der Rückwand, parallel zu dieser, mindestens eine bauteilbestückte Leiterplatte, bei der die Bauteile auf jener der Rückwand abgewandten Seite angeordnet sind, befestigt ist, und welche über die Drehachse der Rückwand hinausragt, und daß unterhalb der Drehachse der Rückwand an der bauteilabgewandten Seite weitere Klemmen, insbesondere Schraubklemmen, parallel zu jenen an der Rückwand, nebeneinander angeordnet sind, welche einerseits mit Leitungsführungen auf der Leiterplatte verlötet sind und andererseits mit externen Leitungen verbunden sind.

Durch die ausschwenkbare Rückwand ist die an der Innenseite dieser angeschraubte Leiterplatte leicht zugänglich. Weiters werden durch die untere Öffnung in der Rückwand die externen Zuleitungen für die Klemmen auf der Leiterplatte geführt. Bei einem Zugriff auf die Leiterplatte an der Innenseite der Rückwand, werden die externen Leitungen keiner mechanischen Beanspruchung ausgesetzt.
Die beiden durch die erfindungsgemäße Anordnung sich ergebenden Klemmenreihen sind ohne Aufklappen der Rückwand zugänglich.
Durch die unterschiedlichen Tiefen und die Lage übereinander der beiden Klemmenreihen ist eine Zuführung der externen Leitungen in zwei getrennten Ebenen gewährleistet, wodurch eine höhere Packungsdichte der Zuleitungen erreicht wird.

Weiters ist durch diese Anordnung auch eine exakte Abgrenzung der verschiedenen Potentialbereiche gegeben. Wenn die Rückwand aus leitendem Material besteht, so dient sie als Schirmung gegen Anlagenstöreinflüsse. Außerdem sind auch extrem kurze Verbindungen zwischen den Stromwandlern und der zugehörigen Elektronik möglich. Da Stromwandlerkreise nie geöffnet werden dürfen, sind demnach Steckverbindungen unzulässig. Eine Lösung wären selbstkurzschließende Stecker, welche jedoch mechanisch aufwendig, teuer und platzintensiv sind. Sie führen zu keinerlei Verbesserung der Funktion, erhöhen durch die Steckkontakte jedoch das Ausfallsrisiko. Als technisch einwandfreie Lösung dafür sind somit Schraubklemmen zu betrachten.

Eine Ausgestaltung der Anordnung im Gehäuse besteht darin, daß auf der Rückwand zwischen mindestens zwei Klemmen, vorzugsweise mittig, ein Winkel befestigt ist, der einen längeren auf die Rückwand normal stehenden Schenkel aufweist, der in einer Ebene mit der Unterkante der Klemmen abschließt. An den Schenkel des Winkels wird der aus den einzelnen zugeführten Leitungen bestehende Strang befestigt.

Von Vorteil ist, daß eine am Gehäuse befestigte Abdeckung für die an der Außenseite der Rückwand befestigten Bauteile vorgesehen ist und diese an der Unter- oder Rückseite eine Öffnung als Zuführung für die externen Leitungen aufweist. Dadurch ist ein Berührungsschutz für diese Bauteile, welche Stromwandler sind, gegeben.

Der wesentliche Vorteil des erfindungsgemäßen Gehäuses und der Anordnung der Elemente in diesem gegenüber den bekannten Gehäusekonstruktionen ist, daß eine hohe Packungsdichte der extern zum Gehäuse zugeführten Lei- tungen erreicht wird und beim Öffnen der Rückwand keine Zugbeanspruchung dieser Leitungen auftritt.

Nachstehend wird die Erfindung an Hand der Zeichnungen noch näher erläutert.

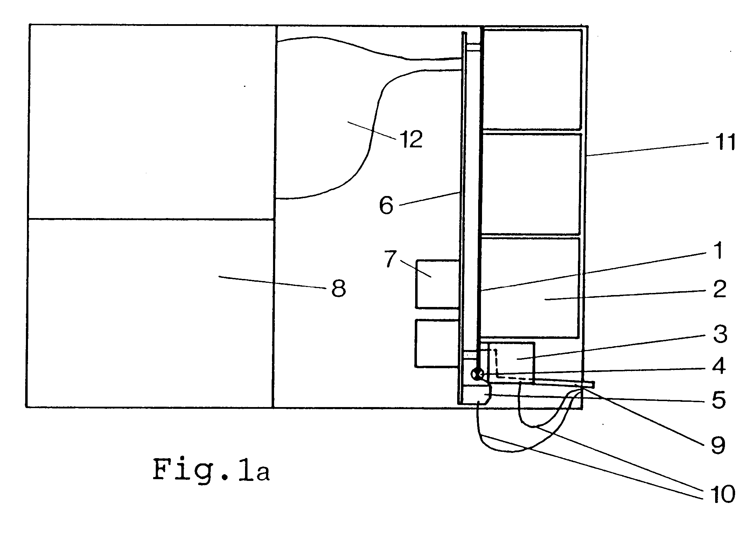

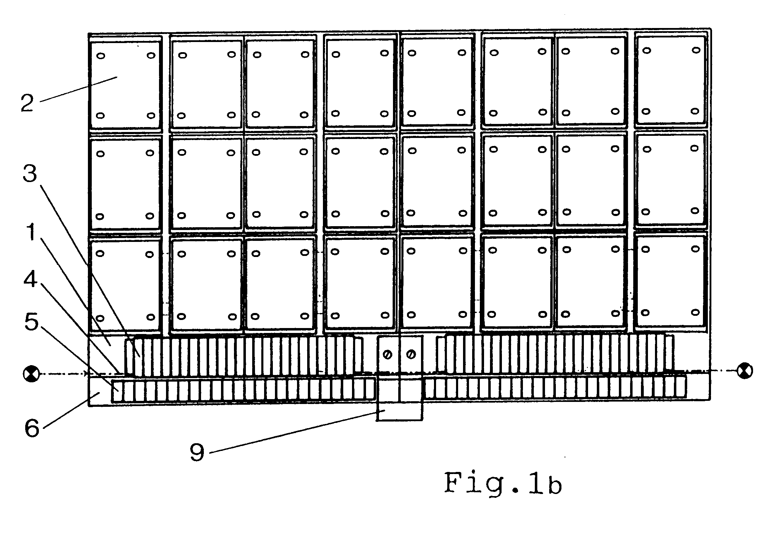

Die Fig. 1a zeigt einen Schnitt durch das erfindungsgemäße Gehäuse und in Fig. 1b ist die Rückansicht bei entfernter Abdeckung dargestellt.

In den Fig. 1a und 1b ist die Rückwand 1 des Gehäuses zu sehen, welche nach rückwärts ausgeschwenkt werden kann. Die Rückwand 1 ist in den beiden Gehäuseseitenwänden mittels an ihr befestigten Zapfen gelagert, wobei die Drehachse 4 in einem Abstand parallel zur Grundplatte des Gehäuses liegt. Die Rückwand 1 reicht nun von der Drehachse 4 bis zur oberen Deckplatte des Gehäuses.

An der Außenseite der Rückwand 1 sind Stromwandler 2 befestigt, deren Sekundäranschlüsse durch die Rückwand 1 ragen. Außen an der Rückwand 1 nahe der Drehachse 4 sind Schraubklemmen 3 nebeneinander befestigt, an denen einerseits die Primärseiten der Stromwandler 2 und andererseits extern zugeführte Leitungen 10 angeschlossen sind. An der Innenseite der Rückwand 1, parallel zu dieser, ist eine bauteilbestückte Leiterplatte 6, bei der die Bauteile auf jener der Rückwand 1 abgewandten Seite angeordnet sind, befestigt. Auf der Leiterplatte 6 sind unter anderem Spannungswandler 7 angeordnet. Die Leiterplatte 6 ragt über die Drehachse 4 der Rückwand 1 hinaus, wobei unterhalb der Drehachse 4 der Rückwand 1 an der bauteilabgewandten Seite ebenfalls Schraubklemmen 5 parallel zu jenen an der Rückwand 1, nebeneinander angeordnet sind. Diese Schraubklemmen 5 sind auf der Leiterplatte angelötet und mit externen Leitungen 10 verbunden.

Auf der Rückwand 1 zwischen zwei Klemmen 3 ist mittig ein Winkel 9 befestigt, der einen längeren auf die Rückwand 1 normal stehenden Schenkel aufweist, der in einer Ebene mit der Unterkante der Klemmen 3 abschließt. Dies ist besonders gut aus Fig. 1b zu sehen.

Weiters ist eine am Gehäuse befestigte Abdeckung 11 für die an der Außenseite der Rückwand 1 befestigten Stromwandler 2 vorgesehen. Diese weist an der Unter- oder Rückseite eine Öffnung als Zuführung für die externen Leitungen 10 auf. Die externen Leitungen 10 sind zu einem Kabelstrang zusammengefaßt, der über die Seitenwand des Gehäuses zu dem Winkel 9 an der Mitte der Drehachse 4 der Rückwand 1 geführt ist, welcher mitschwenkt und somit als Zugentlastung für die Klemmen 3, 5 bzw. als Auffangbügel für die Verdrahtung dient. Das Schwenken der Rückwand führt somit zu keinerlei Belastung der Klemmverbindungen. Das Aufklappen der Rückwand 1 führt nur zu einem Verdrehen der Leitungen 10 um die Längsachse, jedoch nicht zu einer Zugbelastung. Damit ist eine optisch, mechanisch und elektrisch optimale Verkabelung möglich.

Die Verbindung zwischen der Leiterplatte 6 und den Einschüben 8, auf denen die Digitalelektronik, wie Prozessoren angeordnet sind, erfolgt mittels eines Flachbandkabels 12.

## Patentansprüche

1. Gehäuse für Einschübe von Elektronikbaugruppen, sowie die Anordnung von bauteilbestückten Leiterplatten und anderen Bauteilen in diesem, wobei eine Gehäusewand in den beiden benachbarten Gehäuseseitenwänden mittels an ihr befestigten Zapfen nach unten ausschwenkbar gelagert ist und die Drehachse in einem Abstand parallel zur Grundplatte des Gehäuses liegt, dadurch gekennzeichnet, daß die Gehäusewand die Rückwand (1) ist und diese von der Drehachse (4) bis zur oberen Deckplatte des Gehäuses reicht, und daß an der Außenseite der Rückwand (1) Bauteile, insbesondere Stromwandler (2), befestigt sind deren Sekundäranschlüsse durch die Rückwand (1) ragen, und daß außen an der Rückwand (1) nahe der Drehachse (4) Klemmen (3), vorzugsweise Schraubklemmen, nebeneinander befestigt sind, an denen einerseits die Primärseiten der Bauteile, insbesondere Stromwandler (2), und andererseits extern zugeführte Leitungen (10) angeschlossen sind, und daß an der Innenseite der Rückwand (1), parallel zu dieser, mindestens eine bauteilbestückte Leiterplatte (6), bei der die Bauteile auf jener der Rückwand (1) abgewandten Seite angeordnet sind, befestigt ist, und welche über die Drehachse (4) der Rückwand (1) hinausragt, und daß unterhalb der Drehachse (4) der Rückwand (1) an der bauteilabgewandten Seite weitere Klemmen (5), insbesondere Schraubklemmen, parallel zu jenen an der Rückwand (1), nebeneinander angeordnet sind, welche einerseits mit Leitungsführungen auf der Leiterplatte verlötet sind und andererseits mit externen Leitungen (10) verbunden sind.

2. Anordnung im Gehäuse nach Anspruch 1, dadurch gekennzeichnet, daß auf der Rückwand (1) zwischen mindestens zwei Klemmen (3), vorzugsweise mittig, ein Winkel (9) befestigt ist, der einen längeren auf die Rückwand (1) normal stehenden Schenkel aufweist, der in einer Ebene mit der Unterkante der Klemmen (3) abschließt.

3. Anordnung im Gehäuse nach Anspruch 1 oder 2, dadurch gekennzeichnet, daß eine am Gehäuse befestigte Abdeckung (11) für die an der Außenseite der Rückwand (1) befestigten Bauteile vorgesehen ist und diese an der Unter- oder Rückseite eine Öffnung als Zuführung für die externen Leitungen (10) aufweist.

## Claims

1. Housing for plug-in units of electronic assemblies and the arrangement of printed circuit boards, in which components are inserted, and other components in this housing, one housing wall being mounted in the two adjacent housing side walls such that it can be pivoted out downwards by means of pivot pins secured to it, and the axis of rotation lying at a distance from and parallel to the base plate of the housing, characterised in that the housing wall is the rear wall (1) and this extends from the axis of rotation (4) to the top cover plate of the housing, that components, in particular current transformers (2), are secured to the outside of the rear wall (1), the secondary connections of which components project through the rear wall (1), that terminals (3), preferably screw terminals, are secured side by side to the outside of the rear wall (1) close to the axis of rotation, to which terminals the primaries of the components, in particular current transformers (2), are connected on one side and lines (10) leading in from outside on the other, that at least one printed circuit board (6), in which components are inserted, is secured to the inside of the rear wall (1) parallel to the latter, in which board the components are arranged on the side which is distant from the rear wall (1) and which board projects beyond the axis of rotation (4) of the rear wall (1), and that further terminals (5), in particular screw terminals, are arranged side by side parallel to those on the rear wall (1) beneath the axis of rotation (4) of the rear wall (1) on the side which is distant from the components, which terminals are soldered on one side to wiring arrangements on the printed circuit board and are connected on the other to external lines (10).

2. Arrangement in the housing according to claim 1, characterised in that an angle piece (9) is secured to the rear wall (1) between at least two terminals (3), preferably centrally, which angle piece has one longer leg which is normal to the rear wall (1) and which is flush with the bottom edge of the terminals (3) in one plane.

3. Arrangement in the housing according to claim 1 or 2, characterised in that a cover (11), which is secured to the housing, is provided for the components which are secured to the outside of the rear wall (1) and this cover comprises an opening at the underside or back as an inlet for the external lines (10).

## Revendications

1. Boîtier pour tiroirs embrochables de groupes de construction électroniques, ainsi que disposition de plaquettes à circuits imprimés équipées d'éléments de construction et d'autres éléments de construction dans ce boîtier, une paroi de boîtier étant montée de façon à pouvoir pivoter vers le bas dans les deux parois latérales de carter voisines, au moyen de tourillons fixés sur elle et l'axe de rotation étant disposé à distance, parallèlement à la plaque de base du boîtier, caractérisé en ce que la paroi de boîtier est la paroi arrière (1), celle-ci allant de l'axe de rotation (4) jusqu'à la plaque de recouvrement supérieure du boîtier et en ce qu'en face extérieure de la paroi arrière (1) sont fixés des éléments de construction, en particulier un transformateur d'intensité (2), dont les raccordements secondaires passent par la paroi arrière (1) et en ce qu'à l'extérieur de la paroi arrière (1), près de l'axe de rotation (4), des bornes (3) sont fixées les unes à côté des autres, de préférence des bornes à vissage, auxquelles, d'une part, sont raccordés les côtés primaires des éléments de construction, en particulier le transformateur d'intensité (2) et, d'autre part, des lignes électriques (10) amenées de façon externe, et en ce que, sur la face intérieure de la paroi arrière (1), parallèlement à celle-ci, sont disposées au moins une plaquette à circuits imprimés (6), équipée d'éléments de construction et pour laquelle les éléments de construction sont disposés sur la face opposée à la paroi arrière (1) et la plaquette à circuits imprimés passant sur l'axe de rotation (4) de la paroi arrière (1) et en ce qu'au-dessus de l'axe de rotation (4) de la paroi arrière (1) d'autres bornes (5) sont disposées les unes à côtés des autres, sur le côté opposé à l'élément de construction, en particulier des bornes à vissage, parallèlement à celles montées en paroi arrière (1), ces bornes étant, d'une part, brasées à des passages de lignes électriques situés sur la plaquette à circuits imprimés et, d'autre part, reliées à des lignes électriques externes (10).

2. Disposition en boîtier selon la revendication 1, caractérisé en ce qu'en paroi arrière (1) est fixée, entre au moins deux bornes (3), de préférence centralement, une cornière (9) qui présente une branche longue, perpendiculaire par rapport à la paroi arrière (1) et délimitée de façon à se trouver dans le même plan que l'arête inférieure des bornes (3).

3. Disposition en boîtier selon la revendication 1 ou 2, caractérisé en ce qu'est prévu un recouvrement (11) fixé sur le boîtier, pour les éléments de construction fixés en face extérieure de la paroi arrière (1) et ce recouvrement présentant en face inférieure ou arrière une ouverture pour l'amenée des lignes électriques (10) externes.
